# EUROPÄISCHE PATENTSCHRIFT

(11) **EP 1 235 269 B1**
(45) Veröffentlichungstag und Bekanntmachung des Hinweises auf die Patenterteilung: **10.05.2006**
(21) Anmeldenummer: 02002388.3
(22) Anmeldetag: 31.01.2002
(51) Int. Cl.: H01L 21/66, H01L 23/544

(54) **Wafer-Test- und Markierverfahren für Halbleiterbausteine mit Schmelzstrukturen**
Wafer testing and marking process for semiconductor components with fusing structures
Procédé de essai et marquage de tranche pour des composants semi-conducteurs avec des structures fusibles

(30) Priorität: 23.02.2001 DE 10108924
(43) Veröffentlichungstag der Anmeldung: 28.08.2002
(73) Patentinhaber: Infineon Technologies AG, 81669 München (DE)
(72) Erfinder: Abdul-Hak, Ayad, 01108 Dresden (DE); Gratz, Achim, 98587 Steinbach-Hallenberg (DE); Stein von Kamienski, Elard, Dr., 01099 Dresden (DE); Caspary, Dirk, 01109 Dresden (DE); Haibach, Patrick, Dr., 01099 Dresden (DE); Kutter, Christoph, Dr., 01099 Dresden (DE)
(74) Vertreter: Kindermann, Peter

(56) Entgegenhaltungen:
- EP-A- 0 295 065
- DE-C1- 19 960 244
- US-A- 5 326 709
- US-A- 5 768 290
- US-B1- 6 288 561
- PATENT ABSTRACTS OF JAPAN Bd. 013, Nr. 038 (E-709), 27. Januar 1989 (1989-01-27) & JP 63 237431 A (NEC YAMAGATA LTD), 3. Oktober 1988 (1988-10-03)

## Beschreibung

Die vorliegende Erfindung bezieht sich auf ein Wafer-Test-und Markierverfahren für Halbleiterbausteine mit Schmelzstrukturen und insbesondere auf ein verbessertes Wafer-Test-und Markierverfahren für ultradünne Speicher- und Chipkarten-Bausteine.

Wafer-Test- und Markierverfahren sind bei der Herstellung von integrierten Halbleiterschaltungen allgemein bekannt, wobei zur optischen Kennzeichnung fehlerhafter Halbleiterbausteine bzw. Chips (Dies) nach einem Testen der jeweiligen Bausteine auf dem Wafer z.B. Farbpunkte aufgebracht werden, wobei eine maschinelle Erkennbarkeit der Kennzeichnung in der Regel durch bilderkennende Verfahren gewährleistet ist. An Hand dieser Farbpunkte können in nachfolgenden Herstellungsschritten die fehlerhaften Bausteine ausgemustert werden. Eine physisch mit dem Wafer verbundene optische Kennzeichnung hat gegenüber den ebenfalls bekannten Verfahren zur elektronischen Speicherung und Übermittlung des Testergebnisses mittels geeigneter Träger den Vorteil, unmittelbar durch optische Inspektion nachprüfbar zu sein.

Zur Verbesserung einer Ausbeute insbesondere in Speicher-Bausteinen besitzen derartige DRAM- und SRAM-Speicherbausteine Redundanzblöcke, die über Schmelzstrukturen bzw. "fuse"-Bänke zum Reparieren von defekten Teilbereichen des Bausteins ersatzweise verwendet werden können. Zum Programmieren dieser Schmelzstrukturen bzw. zum Reparieren von fehlerhaften Speicherbausteinen können die Schmelzstrukturen entweder elektrisch angesteuert und somit durchgeschmolzen werden oder aber mittels einer Laservorrichtung bearbeitet werden. Des weiteren werden Schmelzstrukturen auch zurVerriegelung von sicherheitskritischen Bauteilen (z.B. SmartCards) nach dem Test eingesetzt.

Während die elektrische Ansteuerung der Schmelzstrukturen eine relativ kostengünstige Möglichkeit zum Programmieren bzw. Reparieren von fehlerhaften Bausteinen ermöglicht, benötigt sie jedoch eine außerordentlich aufwendige Ansteuerschaltung. Demgegenüber sind zumindest die Anfangskosten für eine Laservorrichtung zum Bearbeiten von Schmelzstrukturen außerordentlich hoch, da sie eine sehr genaue Positionierung eines Laserstrahls auf der Schmelzstruktur des Bausteins erfordern. Jedoch ermöglicht der Einsatz einer derartigen Laservorrichtung für Schmelzstrukturen eine starke Vereinfachung der Halbleiterschaltung.

Ein derartiges herkömmliches Wafer-Test- und Markierverfahren für Halbleiterbausteine mit Schmelzstrukturen ist beispielsweise aus der Druckschrift US 5,326,709 bekannt, wobei nach dem Testen der Halbleiterbausteine auf dem Wafer zum Identifizieren von fehlerhaften Bausteinen und nach dem Bearbeiten der Schmelzstrukturen mittels der Laservorrichtung zum Reparieren der fehlerhaften Bausteine ein abschließender Test durchgeführt wird und die fehlerhaften Bausteine mittels einer Markiervorrichtung gekennzeichnet werden. Die Markiervorrichtung stellt hierbei eine herkömmliche "Off-Line-Ink"-Markiervorrichtung dar, bei der Farbpunkte auf die fehlerhaften und zu kennzeichnenden Bausteine aufgebracht werden. Nachteilig ist jedoch bei einem derartigen herkömmlichen Verfahren, dass bei einer weiteren Verarbeitung der Wafer bzw. der Halbleiterbausteine diese Farbpunkte abfallen können und fälschlicherweise ein fehlerhafter Baustein weiterverarbeitet wird.

Insbesondere bei der Herstellung von sehr dünnen bwz. ultradünnen Halbleiterbausteinen wie z.B. COB-Module beim DRAM oder für Chipkarten- bzw. Smartcard- Bausteine ist ein Abdünnen der Wafer auf eine für die Montage erforderliche Stärke notwendig, wodurch herkömmlich aufgebrachte Farbpunkte oftmals abgelöst werden. Ein "Inken" bzw. Kennzeichnen der Bausteine mit Farbpunkten nach dem Abdünnen der Wafer ist wegen der hohen Bruchgefahr beim Handling normalerweise nicht möglich und wegen der nicht durchgängigen physischen Verbindung des Testergebnisses mit dem Baustein in sicherheitskritischen Bereichen bedenklich.

Zur Realisierung von Farbpunkten mit einer minimalen Dicke und maximalen Haftung, wodurch eine Weiterverarbeitung der Wafer nicht behindert und insbesondere ein Durchdrücken der Punkte auf die Rückseite verhindert wird, wurden daher Spezialtinten und speziellen Markiervorrichtungen vorgeschlagen, wie sie beispielsweise aus der Druckschrift JP 2000 06 8337 bekannt sind.

Ferner ist beispielsweise aus der Druckschrift JP 632 37 431 eine Markiervorrichtung zum Kennzeichnen von fehlerhaften Bausteinen bekannt, bei der ein Laserstrahl einen fehlerhaften Baustein zerstört.

Die Verwendung derartiger zusätzlicher Markiervorrichtungen bedeutet jedoch eine erhöhte Komplexität sowie erhöhte Kosten bei der Herstellung von Halbleiterbausteinen.

Der Erfindung liegt daher die Aufgabe zugrunde, ein Wafer-Test- und Markierverfahren für Halbleiterbausteine mit Schmelzstrukturen zu schaffen, welches auf kostengünstige Weise eine äußerst widerstandsfähige Kennzeichnung von fehlerhaften Bausteinen ermöglicht.

Diese Aufgabe wird erfindungsgemäß durch die Maßnahmen des Patentanspruchs 1 gelöst.

Insbesondere durch die gleichzeitige Verwendung der Laservorrichtung zum Bearbeiten der Schmelzstrukturen für das Markieren der fehlerhaften Bausteine erhält man ein äußerst kostengünstiges Markierverfahren. Die ohnehin vorhandene Laservorrichtung für die Schmelzstrukturen wird hierbei zweifach, also auch für das Markieren genutzt. Ferner erhält man ein verbessertes Handling bzw. eine verbesserte Weiterverarbeitbarkeit der Wafer bzw. Halbleiterbausteine, da durch die mittels der Laservorrichtung hervorgerufene Kennzeichnung keine ablösbaren Farbpunkte, sondern eine irreversible Veränderungen der Farbe bzw. des Kontrasts unmittelbar an bzw. in der Oberfläche des Halbleiterbausteins geschaffen werden. Ein fälschlicherweise durchgeführtes Weiterverarbeiten von fehlerhaften Bausteinen aufgrund von abgefallenen Farbpunkten wird dadurch zuverlässig verhindert.

Vorzugsweise wird das Markieren mittels der Laservorrichtung durch Einstellung der Betriebsparameter derart durchgeführt, dass zumindest eine Passivierungsschicht der Bausteine thermisch stark belastet wird. Bei Verwendung von organischen Passivierungsschichten erhält man hierbei eine Schwärzung dieser obersten Schicht. Bei Verwendung von anorganischen Passivierungsschichten werden diese zerstört bzw. abgetragen oder in ihren physikalischen Eigenschaften so verändert (z.B. Phasenumwandlung amorph zu kristallin), dass eine Kontraständerung mittels nachfolgenden Standard-Verarbeitungssystemen erfassbar ist.

Vorzugsweise werden als Betriebsparameter der Laservorrichtung eine Leistung, ein Strahldurchmesser, eine Pulsweite und/oder eine Pulszahl derart eingestellt, dass sich eine gut sichtbare Kennzeichnung eines fehlerhaften Bausteins ergibt. Die Kennzeichnung kann hierbei an eine jeweilige nachfolgend durchgeführte Bilderkennung derart angepasst werden, dass beispielsweise bereits vorhandene Bilderkennungssysteme problemlos weiterverwendet werden können.

Vorzugsweise werden als Halbleiterbausteine Speicher-und/oder Chipkarten-Bausteine verwendet, da diese Bausteine Schmelzstrukturen bzw. sogenannte Laserfuses zur Realisierung 1 einer Redundanz (beispielsweise bei DRAM und SRAM) oder zum Abschalten von nicht benötigten Schaltungsteilen (beispielsweise zur Verbesserung einer Sicherheit bei Chipkarten) auswählen. In den weiteren Ansprüchen sind weitere vorteilhafte Ausgestaltungen der Erfindung gekennzeichnet.

Die Erfindung wird nachstehend an Hand eines Ausführungsbeispiels im einzelnen beschrieben.

Die vorliegende Erfindung wird nachfolgend an Hand von Speicher-Bausteinen, wie sie beispielsweise als DRAMs, SRAMs, EEPROMS usw. bekannt sind, sowie an Hand von Chipkarten-Bausteinen beschrieben, da derartige Halbleiterbausteine spezielle Schmelzstrukturen bzw. "fuse"-Bänke aufweisen, die während oder nach einem Test mit einem Laser hoher Leistung zerstört bzw. durchgeschmolzen werden.

Insbesondere bei Speicher-Bausteinen können mittels derartiger Schmelzstrukturen sowie zusätzlich ausgebildeten Redundanz-Funktionsblöcken im Test erkannte Fehler (z.B. fehlerhafte Speicherzellen, -zeilen und/oder -spalten) repariert werden. Die Schmelzstrukturen bestehen beispielsweise aus elektrisch leitenden Metall- oder Halbleiterbahnen, die mittels des Laserstrahls durchgeschmolzen werden können. Auf eine detaillierte Beschreibung derartiger Schmelzstrukturen sowie dazugehöriger Redundanzfunktionsblöcke wird an dieser Stelle verzichtet, weil sie dem Fachmann allgemein bekannt sind.

In gleicher Weise werden derartige Schmelzstrukturen bzw. "fuse"-Bänke" insbesondere bei Chipkarten-oder Smartcard-Bausteinen dazu benötigt, nach einem Test nicht mehr benötigte Schaltungsteile oder -bereiche zur Erhöhung einer Sicherheit lahmzulegen. Insbesondere bei Chipkarten-Bausteinen, wie sie für Zugangsberechtigungen bei Banken, Kraftfahrzeugen usw. verwendet werden, ist eine derartige Abschaltung von sicherheitsrelevanten Funktionsblöcken der Halbleiterschaltung außerordentlich wichtig, um eine Rückgewinnung von geheimen Daten zuverlässig zu verhindern.

Üblicherweise besitzen derartige Halbleiterbausteine als oberste Schicht eine Passivierungsschicht von einigen 100 nm, die bei der Herstellung auf dem gesamten Wafer ausgebildet wird. Diese Passivierungsschicht besteht beispielsweise aus einer organischen Passivierungsschicht wie z.B. Fotoimid oder einer anorganischen Passivierungsschicht und dient im wesentlichen als Schutz für die Halbleiterschaltungen. Ein Vorteil der vorliegenden Erfindung besteht auch darin, dass keine speziellen Passivierungsschichten verwendet werden müssen, sondern die im jeweiligen Standardprozess zur Verfügung stehenden Schichten verwendet werden können. Die Herstellungskosten lassen sich dadurch wesentlich verringern.

Zum Testen der Vielzahl von auf dem Wafer ausgebildeten Halbleiterbausteine (engl. dies) werden anschließend beispielsweise sogenannte Testpads bzw. -anschlüsse freigelegt und über eine Testsonde mit einer Vielzahl von Messfühlern an einen Tester angeschlossen. Unter Verwendung von vorgegebenen Testmustern bzw. Testprogrammen werden daraufhin die auf dem Wafer jeweils angeschlossenen bzw. kontaktierten Halbleiterbausteine auf ihre Funktionsfähigkeit getestet und bewertet.

Das Entfernen der Passivierungsschicht an den Testanschlüssen kann beispielsweise durch herkömmliches Ätzen durchgeführt werden. Alternativ zu dem vorstehend beschriebenen elektrischen Testverfahren können jedoch auch andere Testverfahren wie z.B. optische Testverfahren zur Identifikation von fehlerhaften Bausteinen verwendet werden. Zur Vermeidung von Wiederholungen bekannter Tatsachen wird an dieser Stelle auf die zur Verfügung stehenden und allgemein bekannten Wafertester verwiesen.

Beim Testen bzw. Markieren eines Speicher-Bausteins mit einer Schmelzstruktur bzw. sogenannten "fuse"-Bänken und dazugehörigen Redundanz-Funktionsblöcken kann anschließend unter Verwendung der im vorhergehenden Schritt ermittelten Testergebnisse für fehlerhafte Bausteine eine Reparatur durchgeführt werden, wobei beispielsweise defekte Speicherzellen, -zeilen oder -blöcke durch die auf der Halbleiterschaltung weiter vorhandenen Redundanz-Speicherzellen, -zeilen oder -blöcke über die Schmelzstrukturen ersetzt werden.

Genauer gesagt, wird eine zum Bearbeiten von derartigen Schmelzstrukturen vorhandene Laservorrichtung derart auf die jeweiligen Verbindungspfade gerichtet, dass beispielsweise ein Durchschmelzen von elektrischen Leiterbahnen (z.B. Polysilizium, Metall usw.) durchgeführt wird.

In gleicher Weise kann bei Verwendung von beispielsweise Chipkarten-Bausteinen auch ein grundsätzliches Laserfusen von allen (auch fehlerfreien) Bausteinen durchgeführt werden, wodurch sicherheitsrelevante Schaltungsteile bzw -blöcke der jeweiligen Halbleiterschaltung abgeschaltet bzw. lahmgelegt werden. In diesem Fall findet keine Reparatur, sondern lediglich ein Abschalten von Teilbereichen der Halbleiterschaltung statt. Wiederum wird jedoch die Laservorrichtung derart auf die Schmelzstrukturen gerichtet, dass einzelne elektrische Leiterbahnen unterbrochen bzw. geschmolzen werden. In gleicher Weise kann auch eine Kombination von Und Abschalten auf jeweilige Halbleiterbausteine angewendet werden.

Anschließend kann optional ein weiteres Testen bzw. ein Abschlusstest der bearbeiteten bzw. reparierten Halbleiterbausteine durchgeführt werden, um beispielsweise ein Reparaturergebnis zu verifizieren oder aber weitere Defekte in den Halbleiterbausteinen aufgrund der mittels der Laservorrichtung vorgenommenen Bearbeitung der Schmelzstrukturen zu erfassen. Dieser weitere Testschritt kann jedoch auch entfallen, wobei unter Verwendung des ersten Testergebnisses nachfolgend ein Markieren der als fehlerhaft beurteilten Halbleiterbausteine erfolgt. Wiederum wird auf eine detaillierte Beschreibung der Laservorrichtung für die Schmelzstrukturen verzichtet, da es sich hierbei um dem Fachmann bekannte käuflich erwerbbare Geräte handelt.

Beim Markieren der im ersten und/oder zweiten Testschritt als fehlerhaft beurteilten Halbleiterbausteine wird jedoch im Gegensatz zum Stand der Technik keine eigenständige Markierungsvorrichtung verwendet, sondern die ohnehin vorhandene Laservorrichtung zum Bearbeiten der Schmelzstrukturen als Markiervorrichtung eingesetzt. Auf diese Weise können die Herstellungsschritte wesentlich vereinfacht werden und insbesondere zusätzliche Transportschritte des Wafers verhindert werden. Darüber hinaus lassen sich aufgrund der zweifachen Verwendung der Laservorrichtung einerseits zur Bearbeitung der Schmelzstrukturen und andererseits zum Markieren von fehlerhaften Bausteinen die Herstellungskosten für Halbleiterbausteine mit Schmelzstrukturen wesentlich verringern. Ferner erhält man eine irreversible Kennzeichnung, die auch für ultradünne Wafer eine problemlose Weiterverarbeitung ermöglicht.

Im Markierungsschritt werden demzufolge die Betriebsparameter der Laservorrichtung für die Schmelzstrukturen derart neu eingestellt, dass zumindest eine oberste Schicht des Wafers (üblicherweise die Passivierungsschicht der Bausteine) thermisch stark belastet wird. Bei Verwendung einer organischen Passivierungsschicht wie beispielsweise Fotoimid entsteht dabei eine intensive Verfärbung bzw. Schwärzung innerhalb der Passivierungsschicht, welche eine gewünschte optische Kennzeichnung der fehlerhaften Halbleiterbausteine bewirkt. Im Gegensatz zu den üblicherweise verwendeten Farbpunkten bzw. Tintenpunkten verändert diese Kennzeichnung eine Dicke der Halbleiterbausteine nicht und ist insbesonderelnicht ablösbar, wodurch eine Weiterverarbeitung von fehlerhaften Bausteinen aufgrund von abgefallenen Farbpunkten zuverlässig verhindert wird. Insbesondere bei der Herstellung von ultradünnen Halbleiterbausteinen, wie sie beispielsweise bei Chipkarten, Smartcards oder COB-Modulen beim DRAM verwendet werden, kann demzufolge ein Abdünnen der gekennzeichneten Wafer bis üblicherweise 150 bis 180µm problemlos durchgeführt werden.

Neben der vorstehend beschriebenen Einfärbung der Passivierungsschicht durch die thermische Belastung mittels des Laserstrahls kann beispielsweise bei Verwendung von anorganischen Passivierungsschichten diese auch komplett zerstört bzw. abgetragen werden, wobei ein optischer Kontrast durch variierende Schichtdicken und einen technologieabhängigen Aufbau der darunterliegenden Schichten bestimmt und ausgewertet werden kann. Auch eine derartige Kennzeichnung ist naturgemäß irreversibel und nicht auftragend, womit insbesondere die beiden Hauptprobleme des Inkens bzw. Markierens mit Farbpunkten entfallen.

Da die Laservorrichtung für die Bearbeitung der Schmelzstrukturen der Halbleiterbausteine sehr hohe Anforderungen hinsichtlich seiner Positionierbarkeit des Laserstrahls auf dem Halbleiterbaustein erfüllt und seine Betriebsparameter darüber hinaus sehr leicht modifizierbar sind, kann eine Realisierung der Markiervorrichtung durch die Laservorrichtung auf besonders einfache Weise durchgeführt werden.

Vorzugsweise werden hierbei in Abhängigkeit von einem jeweiligen Testergebnis im vorher durchgeführten Testschritt als Betriebsparameter der Laservorrichtung eine Leistung, ein Strahldurchmesser, eine Pulsweite und/oder eine Pulszahl derart eingestellt, dass eine zuverlässige Kennzeichnung der Halbleiterbausteine beispielsweise in der Passivierungsschicht durchgeführt wird.

Aufgrund der hohen Präzision von derartigen für Schmelzstrukturen eingesetzten Laservorrichtungen besteht darüber hinaus die Möglichkeit einer speziellen Anpassung für nachfolgend durchgeführte Bilderkennungsschritte, wobei beispielsweise nicht nur Punkte sondern erfass- und auswertbare Strukturen in die Oberfläche der Halbleiterbausteine eingebrannt werden können. Die Kennzeichnung mittels der Laservorrichtung lässt sich dadurch so gestalten, dass beispielsweise auf Inkpunkte optimierte Bilderkennungssysteme in späteren Bearbeitungsschritten ohne weitere Modifikation weiterverwendet werden können. Die Integrierbarkeit des erfindungsgemäßen Wafer-Test- und Markierverfahrens ist daher besonders einfach und kostengünstig.

Die Erfindung wurde vorstehend an Hand von Speicher- und Chipkarten-Bausteinen beschrieben. Sie ist jedoch nicht darauf beschränkt und umfasst vielmehr alle weiteren Halbleiterbausteine, welche Laser-Schmelzstrukturen zur Realisierung einer Reparaturfähigkeit oder Modifikation der Funktionsfähigkeit der Halbleiterschaltung aufweisen.

## Patentansprüche

1. Wafer-Test- und Markierverfahren für Halbleiterbausteine mit Schmelzstrukturen bestehend aus den Schritten:
a) Testen der Halbleiterbausteine auf dem Wafer zum Identifizieren von fehlerhaften Bausteinen;
b) Bearbeiten der Schmelzstrukturen der Bausteine mittels einer Laservorrichtung zum Reparieren der fehlerhaften Bausteine und/oder zum Abschalten von nicht benötigten Schaltungsteilen in fehlerfreien Bausteinen; und
c) Markieren der fehlerhaften Bausteine und/oder nicht reparierbaren Bausteine auf dem Wafer,
**dadurch gekennzeichnet , dass**
das Markieren in Schritt c) mittels der Laservorrichtung zum Bearbeiten der Schmelzstrukturen durchgeführt wird.

2. Wafer-Test- und Markierverfahren nach Patentanspruch 1, **dadurch gekennzeichnet , dass** beim Markieren in Schritt c) die Betriebsparameter der Laservorrichtung derart eingestellt werden, dass zumindest eine Passivierungsschicht der Bausteine thermisch stark belastet wird.

3. Wafer-Test- und Markierverfahren nach Patentanspruch 2, **dadurch gekennzeichnet , dass** die Passivierungsschicht der Bausteine durch die thermische Belastung eine irreversible physikalische Veränderung erfährt, die optisch erfassbar ist.

4. Wafer-Test- und Markierverfahren nach Patentanspruch 2 oder 3, **dadurch gekennzeichnet , dass** als Passivierungsschicht eine organische und/oder anorganische Schicht oder ein Mehrschichtaufbau aus vorgenannten Schichten verwendet wird.

5. Wafer-Test- und Markierverfahren nach einem der Patentansprüche 2 bis 4, **dadurch gekennzeichnet , dass** als Betriebsparameter der Laservorrichtung eine Leistung, ein Strahldurchmesser, eine Pulsweite und/oder eine Pulszahl eingestellt wird.

6. Wafer-Test- und Markierverfahren nach einen der Patentansprüche 1 bis 5, **dadurch gekennzeichnet , dass** das Markieren in Schritt c) an eine nachfolgend durchzuführende Standard-Bilderkennung angepasst ist.

7. Wafer-Test- und Markierverfahren nach einem der Patentansprüche 1 bis 6, **dadurch gekennzeichnet , dass** die Halbleiterbausteine Speicher- und/oder Chipkarten-Bausteine darstellen.

8. Wafer-Test- und Markierverfahren nach einem der Patentansprüche 1 bis 7, **dadurch gekennzeichnet , dass** das Testen in Schritt a) einen elektrischen Funktionstest der Halbleiterbausteine auf dem Wafer darstellt.

9. Wafer-Test- und Markierverfahren nach einem der Patentansprüche 1 bis 8, **dadurch gekennzeichnet , dass** nach dem Bearbeiten der Schmelzstrukturen in Schritt b) ein weiteres Testen der Halbleiterbausteine zum Identifizieren von fehlerhaften und/oder nicht reparierbaren Bausteinen auf dem Wafer durchgeführt wird.

## Claims

1. Wafer testing and marking method for semiconductor components having fuse structures, comprising the following steps:
a) testing of the semiconductor components on the wafer for the purpose of identifying defective components;
b) processing of the fuse structures of the components by means of a laser device for the purpose of repairing the defective components and/or for the purpose of turning off unrequired circuit parts in defect-free components; and
c) marking of the defective components and/or irreparable components on the wafer,
**characterized in that**
the marking in step c) is carried out by means of the laser device for processing the fuse structures.

2. Wafer testing and marking method according to Patent Claim 1, **characterized in that**, during the marking in step c), the operating parameters of the laser device are set in such a way that at least one passivation layer of the components is subjected to great thermal loading.

3. Wafer testing and marking method according to Patent Claim 2, **characterized in that** the passivation layer of the components experiences an irreversible physical alteration as a result of the thermal loading, which alteration can be detected optically.

4. Wafer testing and marking method according to Patent Claim 2 or 3, **characterized in that** an organic and/or inorganic layer or a multilayer construction comprising aforementioned layers is used as the passivation layer.

5. Wafer testing and marking method according to one of Patent Claims 2 to 4, **characterized in that** a power, a beam diameter, a pulse width and/or a pulse number is set as operating parameters of the laser device.

6. Wafer testing and marking method according to one of Patent Claims 1 to 5, **characterized in that** the marking in step c) is adapted to a standard image recognition that is subsequently to be carried out.

7. Wafer testing and marking method according to one of Patent Claims 1 to 6, **characterized in that** the semiconductor components constitute memory and/or smart card components.

8. Wafer testing and marking method according to one of Patent Claims 1 to 7, **characterized in that** the testing in step a) constitutes an electrical functional test of the semiconductor components on the wafer.

9. Wafer testing and marking method according to one of Patent Claims 1 to 8, **characterized in that** the processing of the fuse structures in step b) is followed by carrying out a further testing of the semiconductor components for the purpose of identifying defective and/or irreparable components on the wafer.

## Revendications

1. Procédé d'essai et de marquage de tranche, pour des modules à semi-conducteurs à structures fusibles, les étapes du procédé étant les suivantes :
a) soumettre à un essai la tranche des modules à semi-conducteurs pour identifier des modules défectueux,
b) traiter les structures fusibles des modules à l'aide d'un dispositif laser pour réparer les modules défectueux et/ou pour neutraliser des parties de circuit non nécessaires sur des modules défectueux et
c) marquer sur la tranche les modules défectueux et/ou les modules non réparables,
**caractérisé en ce que** le marquage à l'étape c) est réalisé à l'aide du dispositif laser pour traiter les structures fusibles.

2. Procédé d'essai et de marquage de tranche selon la revendication 1, **caractérisé en ce que** lors du marquage à l'étape c), les paramètres pour faire fonctionner le dispositif laser sont réglés de telle manière qu'au moins une couche de passivation des modules est très sollicitée thermiquement.

3. Procédé d'essai et de marquage sur la tranche selon la revendication 2, **caractérisé en ce que**, du fait de la sollicitation thermique, la couche de passivation des modules est soumise à une modification physique irréversible qui peut être détectée visuellement.

4. Procédé d'essai et de marquage sur la tranche selon la revendication 2 ou 3, **caractérisé en ce que** la couche de passivation utilisée est une couche organique et/ou minérale ou une structure constituée de plusieurs des couches ci-dessus.

5. Procédé d'essai et de marquage sur la tranche selon l'une des revendications 2 à 4, **caractérisé en ce qu'**on règle une puissance, un diamètre de rayon, une largeur d'impulsion et/ou un nombre d'impulsion pour servir de paramètres pour faire fonctionner le dispositif laser.

6. Procédé d'essai et de marquage sur la tranche selon l'une des revendications 1 à 5, **caractérisé en ce que** le marquage à l'étape c) est ajusté à une reconnaissance d'images habituel à réaliser ultérieurement.

7. Procédé d'essai et de marquage sur la tranche selon l'une des revendications 1 à 6, **caractérisé en ce que** les modules à semi-conducteurs représentent des modules de mémoire et/ou de cartes à puce.

8. Procédé d'essai et de marquage sur la tranche selon l'une des revendications 1 à 7, **caractérisé en ce que** l'essai à l'étape a) représente un essai de fonctionnement électrique, de la tranche des modules, à semi-conducteurs sur la tranche.

9. Procédé d'essai et de marquage sur la tranche selon l'une des revendications 1 à 8, **caractérisé en ce que**, après que les structures fusibles ont été traitées à l'étape b), la tranche des modules à semi-conducteurs subit un autre essai pour identifier des modules défectueux et/ou non réparables.
